(19) Europäisches Patentamt
European Patent Office
Office européen des brevets

(11) **EP 2 915 254 B1**

(12) **EUROPÄISCHE PATENTSCHRIFT**

(45) Veröffentlichungstag und Bekanntmachung des Hinweises auf die Patenterteilung:
**16.11.2016 Patentblatt 2016/46**

(21) Anmeldenummer: **15701029.9**

(22) Anmeldetag: **26.01.2015**

(51) Int Cl.:
***H03K 17/955*** *(2006.01)*

(86) Internationale Anmeldenummer:
**PCT/EP2015/051433**

(87) Internationale Veröffentlichungsnummer:
**WO 2015/113918 (06.08.2015 Gazette 2015/31)**

(54) **AUSWERTEVERFAHREN FÜR SENSORSIGNALE**

EVALUATION METHOD FOR SENSOR SIGNALS

PROCÉDÉ D'ÉVALUATION DE SIGNAUX DE CAPTEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.01.2014 DE 102014100974**

(43) Veröffentlichungstag der Anmeldung:
**09.09.2015 Patentblatt 2015/37**

(73) Patentinhaber: **Huf Hülsbeck & Fürst GmbH & Co. KG**
**42551 Velbert (DE)**

(72) Erfinder:
• **STEUERMANN, Heinz-Paul**
**41363 Jüchen (DE)**
• **SIEG, Berthold**
**46240 Bottrop (DE)**

(74) Vertreter: **Zenz Patentanwälte Partnerschaft mbB**
**Rüttenscheider Straße 2**
**45128 Essen (DE)**

(56) Entgegenhaltungen:
EP-A1- 2 616 287        DE-A1-102012 100 960
US-A1- 2002 173 935

EP 2 915 254 B1

**Beschreibung**

Die Erfindung betrifft ein Auswerteverfahren für Sensorsignale. Insbesondere betrifft die Erfindung ein Verfahren zum Einsatz mit Sensoreinrichtungen, die ein zeitlich veränderliches Signal in Abhängigkeit von abgetasteten Vorgängen bereitstellen.

Zeitlich veränderliche Sensorsignale werden an zahlreichen Einsatzpunkten verwendet. Beispielsweise werden solche Signale mit Hilfe von Annäherungssensoren erfasst, welche die Annäherung von Gegenständen oder Personen in einem Bereich abtasten. Auch im Bereich der Erfassung von Bediengesten, ebenfalls detektiert durch Annäherungssensoren oder aber beispielsweise durch berührungsempfindliche Oberflächen (kapazitive Displays), werden zeitlich veränderliche Sensorsignale erfasst.

Die Zeitfolge von Sensorwerten wird anhand eines Auswertealgorithmus analysiert, um eine Interpretation der Sensorwerte zu erlauben. Beispielsweise können Annäherungssensoren ausgewertet werden, um an Fahrzeugen den Bedienwunsch oder Öffnungswunsch an Fahrzeugtüren oder Fahrzeugklappen zu ermitteln.

Die EP 2 616 287 A1 beschreibt ein derartiges Verfahren, bei dem kapazitive Sensorelektroden eine zeitliche Abfolge von Sensorwerten erfassen, die anschließend einem neuronalen Netzwerk zur Auswertung zugeführt werden.

Aus der US 2002/173935 A1 ist ein Verfahren bekannt, bei dem ein Sensorsignal einer kontinuierlichen Mittelwertbildung zugeführt wird und die Standardabweichung eines Messparameters bestimmt wird. Der aktuelle Messwert wird mit diesen Größen zur Signalauswertung verglichen.

Das Verfahren aus der DE 10 2012 100960 A1 verwendet zur Erfassung mehrere Sensoren, wobei die Signale relativ zueinander ausgewertet werden.

Anhand solcher Auswertungen soll sichergestellt werden, dass der klare Betätigungswunsch oder eine Befehlsauswahl durch einen Benutzer von einer versehentlichen Betätigung oder einem sonstigen Änderungsvorgang der Umgebung unterschieden wird. Andererseits muss aufgrund der einer menschlichen Betätigung innewohnenden Ungenauigkeit eine gewisse Toleranz bei der Erkennung berücksichtigt werden.

Für die Auswertung werden dabei insbesondere Schwellwertvergleiche, Offsetkorrekturen und Prüfungen der Änderungsgeschwindigkeit von Signalen herangezogen.

Die bekannten Verfahren stellen jedoch an die Berechnungsmöglichkeiten der zugehörigen technischen Einrichtungen, wie z. B. Prozessoren, teilweise zu hohe Ansprüchen. Es ist erstrebenswert, die Auswertung mit möglichst einfachen und verlässlichen Berechnungsverfahren durchzuführen. Die Erfindung hat daher zur Aufgabe, ein verbessertes Verfahren zur Mustererkennung in Sensorsignalen bereitzustellen.

Diese genannte Aufgabe löst das erfindungsgemäße Verfahren mit den Merkmalen des Patentanspruches 1.

Gemäß der Erfindung wird ein zeitlicher Signalverlauf an einer Sensoreinrichtung erfasst. Die Sensoreinrichtung kann eine beliebige Einrichtung sein, welche zeitlich veränderbare Sensorsignale liefert die ein zu erfassendes Ereignis begleiten können. Beispielsweise kann die Sensoreinrichtung durch Annäherungssensoren, optische Sensoren, Ultraschallsensoren oder Berührungssensoren gebildet werden.

Das zeitlich veränderliche Sensorsignal wird erfindungsgemäß in zeitliche Abschnitte des Signalverlaufes gegliedert. Die Sensorauswertung erfolgt bei technischer Realisierung immer diskret, also in Zeitabständen, wobei diese Zeitabstände durchaus gering gewählt werden können. Gemäß dem erfindungsgemäßen Verfahren werden entlang der Zeitachse ein oder mehrere gemessene Sensorwerte zu zeitlichen Abschnitten zusammengefasst. In diesem Abschnitt weist das Sensorsignal einen Wert oder eine Folge von Werten auf.

Zu jedem der Abschnitte wird nun ein oberer Ist-Intervallwert ($IU_N$) und ein zugehöriger unterer Ist-Intervallwert ($IL_N$) berechnet, wobei N einen fortlaufenden Index der Intervalle bezeichnet. Es werden also Intervallgrenzen aus den Sensorwerten im betrachteten Abschnitt abgeleitet. Diese Intervallwerte bestimmen einen Wertebereich [$IL_N$, $IU_N$], der in Beziehung zu den Signalwerten in dem betrachteten Abschnitt steht.

Wesentlich ist, dass aus einer Signalfolge bei der zu jedem Zeitpunkt ein Signalwert vorliegt, abschnittsweise Intervallbereiche [$IL_N$, $IU_N$] mit der Größe (oder auch Breite) $IU_N$-$IL_N$ gebildet werden. Bei der Betrachtung eines eindimensionalen Signalwertes, darstellbar aus Werten entlang einer Zeitachse, wird auf diese Weise die durch Verbindung der Werte gebildete Linie zu einem zweidimensionalen Intervallband der Breite $IU_N$-$IL_N$ aufgeweitet. Gemäß der Erfindung wird ein Mengenvergleich durchgeführt, wobei einerseits eine Menge aus dem aktuellen Signalverlauf erzeugt wird und andererseits eine Menge als Schablone zum Vergleich gespeichert ist.

Wie die Intervallwerte aus den Messwerten berechnet werden kann von der Art der Signalwerte abhängen. Beispielsweise können diskrete Werte zu den Signalwerten hinzuaddiert werden oder abgezogen werden, um zu den Intervallgrenzen zu gelangen. Es kann jedoch auch eine Abhängigkeit der Intervallgrenzen von den Signalwerten oder deren Änderungsrate vorgenommen werden. Bei Bereichen mit hoher Signaldynamik kann beispielsweise der Abstand der Intervallgrenzen vergrößert oder verkleinert werden. Außerdem können die Signalgrenzen auch berechnet werden, indem zunächst die vorliegenden Signalwerte einer Vorbehandlung, beispielsweise einer Mittelwertbildung oder sonstiger Filterung unterworfen werden.

Zu dem erfassten Signalverlauf liegt erfindungsgemäß nach Ausführung dieser Schritte ein zeitlicher Intervallbereichs-Verlauf $(IU_N)_N$, $(IL_N)_N$ vor. Es ist nun erfindungsgemäß vorgesehen, diesen Intervallbereich mit einem gespeicherten Intervallbereich-Verlauf $(VIU_N)_N$, $(VIL_N)_N$, einer Schablone, zu vergleichen. Dieser Schablonenbereich stellt von einem Mustersignal einen entsprechenden Intervallbereich dar. Beispielsweise wird der Schablonenbereich gebildet, indem dieselbe Berechnung zur Intervallbestimmung angewandt wird, wie auf die Messdaten. Dazu können jedoch ggf. andere Parameter angewandt werden. Ein Vergleichssignal, z.B. das Signal eines Sensors bei einer zu Erfassenden Betätigung, führt dann zu einer gespeicherten Schablone, die zum Vergleich mit den Intervallen um die tatsächlichen Messwerte herangezogen wird. Es wird dabei geprüft, ob der berechnete Intervallbereich mit seinem Zeitverlauf in einen gespeicherten Schablonenbereich eingepasst werden kann. Wie weiter unten in den Ausführungsbeispielen gezeigt, ist dies nicht gleichwertig mit der Prüfung, ob der ursprüngliche Signalverlauf oder eine gefilterte Version des ursprünglichen Signalverlaufes, innerhalb der Schablone liegt. Durch die Ausdehnung der Messwerte in wenigstens eine weitere Dimension, also beispielsweise die Wandlung eines Signallinienverlaufes in ein Signalband, und den Vergleich dieses Signalbandes mit einer Schablone kann eine verbesserte Vergleichsanalyse durchgeführt werden. Dies liegt daran, dass ein Vergleich in mehr Dimensionen als der ursprünglichen Signaldimension durchgeführt wird. Auch wenn die Intervallgrenzen des Ist-Intervalls aus dem ursprünglichen Signalverlauf abgeleitet sind, ist die erfindungsgemäße Vergleichsoperation dem Vergleich mit dem ursprünglichen Signalverlauf überlegen. Beispielsweise können auf diese Weise auch bestimmte Signalabschnitte stärker gewichtet werden als andere oder beispielsweise weitere Objekte auf dem Signalband operieren.

In einer bevorzugten Ausführungsform der Erfindung wird der zeitliche Signalverlauf derart eingeteilt, dass jeder Abschnitt wenigstens ein Signalmesswert enthält.

Grundsätzlich ist es zwar möglich, die Abschnittseinteilungen kleiner zu wählen als die Abstände zwischen den Signalerfassungen, und dann die Intervallgrenzen zu interpolieren oder zu extrapolieren. Vorzugsweise ist jedoch zumindest ein Signalwert in jedem der Abschnitte vorhanden. In Zeiten, in denen signalfreie Bereiche vorliegen, beispielsweise aufgrund von Störvorgängen oder einer zur Energieeinsparung verringerten Taktung der Sensoreinrichtung, führen dann zu einer Vergrößerung der Abschnittsbereiche.

In einer vorteilhaften Ausführungsform der Erfindung werden die abgeleiteten Intervalle zu jedem Signalabschnitt derart gewählt, dass die Signalwerte in dem betrachteten Abschnitt zwischen den berechneten Intervallwerten liegen. Die ermittelten Intervalle bilden dann eine beabstandete, einhüllende Kontur zu den Signalwerten.

In einer Weiterbildung der Erfindung wird außerdem berücksichtigt, dass die Signalwerte abhängig von zeitlich veränderten Umgebungsbedingungen sind, beispielsweise veränderlichen Belegungen und Verschmutzungen der Sensoreinrichtung oder der Umweltbedingungen.

In dieser Ausführungsform wird aus dem Signalverlauf oder dem Signalverlauf und einer Schablone eine mindestens stückweise mindestens stetige Funktion für eine Transformation berechnet. Beispielsweise kann eine stückweise affine Funktion für eine Transformation, die eine Offset-Korrektur darstellt, berechnet werden. Im Rahmen dieses Beispiels wird eine stückweise mindestens stetige Funktion für eine Offset-Korrektur berechnet und von dem zeitlichen Signalverlauf abgezogen, um die Offset-Korrektur herbeizuführen. Die Anzahl der Stützstellen der stückweise affinen Funktion kann in Abhängigkeit von dem erwarteten Signalverlauf gewählt werden. Beispielsweise kann es ausreichen, zwei oder drei Stützstellen zu verwenden, um beispielsweise eine lineare Offsetveränderung über die Messdauer zu kompensieren. Dies kann beispielsweise durch einen Abfall oder Anstieg des Signals über die Messdauer erforderlich werden. Eine stückweise affine Funktion, beispielsweise mit einer Stützstelle am Anfang und am Ende des Signalbereiches, entspricht der Korrektur des Signalverlaufes mit einer linearen Funktion.

Die transformierten Daten, wobei die Transformation im angeführten Beispiel eine Korrektur ist, werden dann anschließend verwendet, um anhand dieser angepassten Daten die Intervallwerte zu berechnen. Auf diese Weise findet die gespeicherte Vergleichsschablone jederzeit der Anwendung angemessene, transformierte Daten vor und es kann eine noch spezifischere Auswertung vorgenommen werden.

Zusätzlich oder alternativ ist es auch möglich, den Signalverlauf einer Filterung zu unterwerfen, bevor die Intervallgrenzen berechnet werden. Die Filterung kann beispielsweise in einer Glättung bestehen, es sind jedoch auch andere Filterungen, beispielsweise Filter zur Rauschunterdrückung (z. B. Wiener-Filter) einsetzbar. In einer alternativen Gestaltung wird die Filterung auch zusätzlich oder alternativ auf die Intervallgrenzen angewendet.

In einer Weiterbildung der Erfindung kann vor einem Vergleich der Mengen und Intervalle eine Normalisierung der aus den Messwerten erzeugten Menge in den Intervallgrenzen erfolgen.

Eine Normalisierung bezieht sich hierbei auf den Vergleich der Breite der aus den Messwerten erzeugten Intervallen mit der Breite der Muster-Schablone. Dieser Vergleich kann abschnittsweise oder auch gemittelt über die gesamte Messdauer erfolgen. Durch die Normalisierung werden Störungseffekte, insbesondere Rauschen gemindert, welche bei der aktuellen Messung vorliegen können, jedoch bei der Erzeugung der Schablone nicht vorhanden waren. In einer einfachen Gestaltung wird ein Faktor berechnet, mit welchem die Intervallgrenzen multipliziert werden, wobei der Faktor durch eine Division der mittleren Breite der Schablone durch die mittlere Breite der zu den Messwerten berechneten Intervallbreiten erfolgt. Die Normalisierung kann in Kombination mit einer Filterung und/oder der Offset Korrektur angewandt werden.

Die Erfindung wird nun anhand der beiliegenden Figuren näher erläutert.

Figur 1 zeigt beispielhaft einen schematischen Signalverlauf einer Sensoreinrichtung;
Figur 2 zeigt in schematischer Weise einen erfindungsgemäßen Bereichsvergleich eines ungültigen Signalverlaufes;
Figur 3 zeigt in schematischer Weise einen zur erfindungsgemäßen Auswertung vorgesehenen Signalverlauf;
Figur 4 zeigt in schematischer Weise den erfindungsgemäßen Vergleichsbereich einer gültigen Signalantwort.

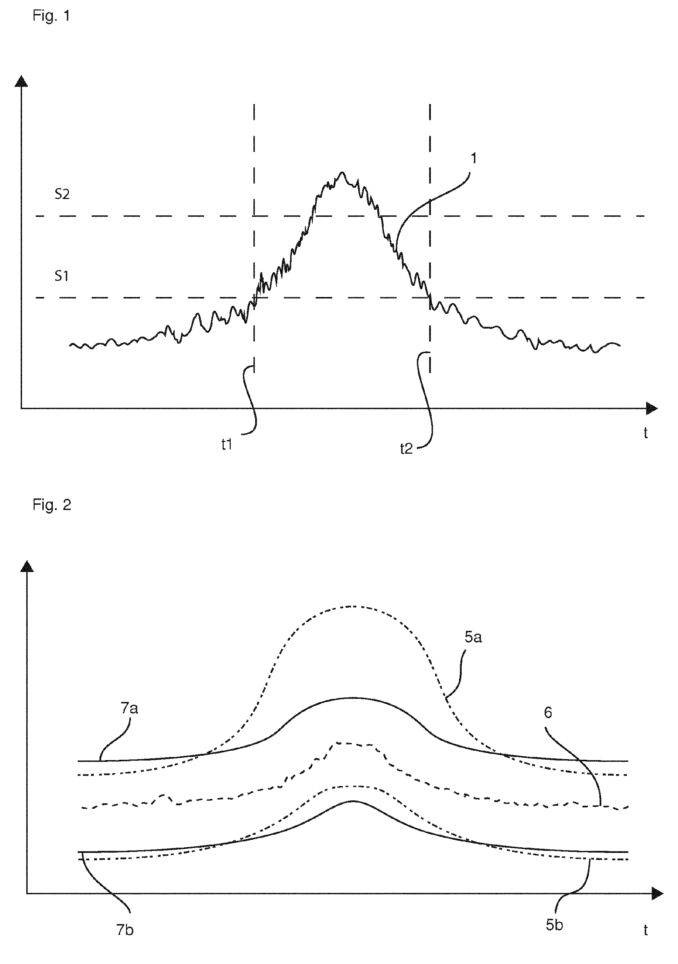

In Figur 1 ist in schematischer Weise ein Signalverlauf 1 dargestellt, der entlang einer Zeitachse unterschiedliche Signalstärken darstellt. Figur 1 zeigt dabei beispielhaft eine Auswertung eines solchen Signalverlaufes gemäß dem Stand der Technik.

Zur Untersuchung des Signalverlaufes werden Schwellwertvergleiche mit Schwellwerten S1 und S2 durchgeführt. Es wird also der Signalverlauf 1 überwacht, bis zum Zeitpunkt t1 der Schwellwert S1 überstiegen wird. Außerdem wird überwacht, ob der Signalwert wieder unterhalb des Schwellwertes S1 absinkt, was zum Zeitpunkt t2 der Fall ist. Zwischen diesen Zeitpunkten muss der Signalwert außerdem den Schwellschwert S2 überstiegen haben. Liegen die Zeitpunkte t1 und t2 innerhalb eines vorgegebenen Intervalls und sind somit alle Bedingungen erfüllt, wird eine positive und gültige Signalantwort erkannt. Dies ist ein beispielhaftes Auswerteverfahren gemäß dem Stand der Technik, bei der Signalverlauf an sich zur Auswertung mit verschiedenen Vergleichsoperationen herangezogen wird.

Figur 2 zeigt das erfindungsgemäße Konzept, welches eine Art Schablonenvergleich von verschiedenen Flächen vornimmt. Eine Auswerteschablone ist durch die obere Intervallgrenze 5a und die untere Intervallgrenze 5b definiert. Zwischen diesen Intervallgrenzen ist eine Fläche begrenzt, welche gültige Antwortbereiche definiert. Ebenfalls dargestellt ist eine beispielhafte Signalantwort 6, die jedoch keine gültige Signalantwort darstellt. Die Signalantwort 6 selbst liegt innerhalb des Intervalls, welches durch die Intervallgrenze 5a und 5b definiert wird. Allerdings wird erfindungsgemäß nicht der Signalverlauf 6 für die Auswertung herangezogen. Zum Signalverlauf 6 werden gemäß einer Rechenvorschrift ebenfalls Intervallgrenzen berechnet, die eine Fläche einschließen. Die zu dem Signalverlauf 6 gehörenden Intervallgrenzen sind der Verlauf 7a und 7b. Es ist erkennbar, dass abschnittsweise die Intervallgrenze 7a und 7b durch Zusammenfassung mehrerer Messwerte und damit einer Glättungsfunktion aus der Signalfunktion 6 generiert wurden. Es ist ebenfalls erkennbar, dass der durch die aus dem Signalverlauf 6 generierten Intervallgrenzen 7a und 7b eingeschlossene Bereich nicht vollständig innerhalb des Schablonenbereiches, definiert durch 5a und 5b liegt. Da die aus dem Signalverlauf 6 abgeleitete Fläche in diesem Ausführungsbeispiel keine Teilmenge der Schablonenfläche ist, wird die Signalantwort als ungültig erkannt.

Wesentlich ist, dass die Auswertung durch einen Vergleich stattfindet, wobei der Vergleichsbereich zumindest eine Ordnung höher ist als die Dimension des Ursprungssignales. Grundsätzlich wäre bei zweidimensionalen Daten auch eine Entsprechung im dreidimensionalen Auswertungsraum denkbar.

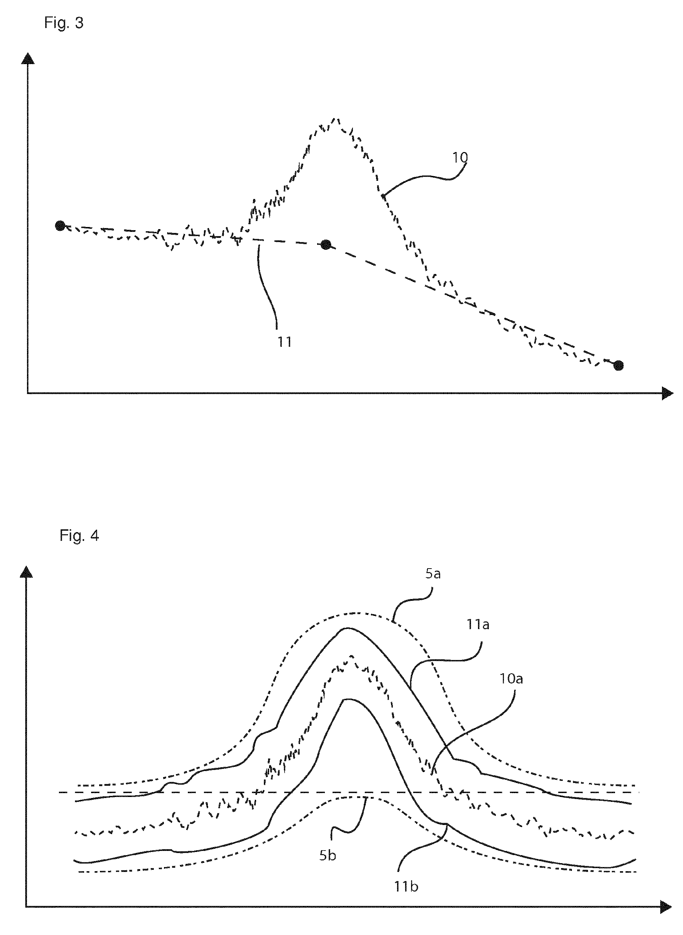

Figur 3 zeigt einen Signalverlauf, der ebenfalls denselben Schemagrenzen wie in der Figur 2 dargestellt zugeführt werden soll. Es ist jedoch erkennbar, dass der Signalverlauf über die Erfassungsdauer abfällt. Dies kann beispielsweise durch eine Änderung der Umgebungsbedingungen oder eine ungünstige Erfassungssituation hervorgerufen werden.

Wie in Figur 3 dargestellt, wird zu dem Signalverlauf 10 eine stückweise affine Funktion 11 berechnet, die in diesem Beispiel nur drei Stützstellen aufweist. Diese stückweise affine Funktion 11 wird zur Offset-Korrektur des Signalverlaufes 10 herangezogen, um einen Signalverlauf 10a zu bilden. Zu diesem korrigierten Signalverlauf 10a werden wiederum stückweise Intervallgrenzen 11a und 11b berechnet, wie in Abbildung 4 gezeigt. Der durch die stückweise affine Funktion 11 korrigierte Signalverlauf 10a liegt ebenfalls, wie in Figur 2 der Signalverlauf 6, zwischen den Signalschablonengrenzen 5a und 5b. In diesem Fall liegt jedoch auch die Fläche, eingeschlossen zwischen den Intervallgrenzen 11a und 11b innerhalb der Schablonengrenzen, so dass hier ein gültiges Betätigungssignal erkannt werden kann.

Im Folgenden wird anhand eines Ausführungsbeispiels die tatsächliche Berechnung von Intervallgrenzen zu einem Muster-Signalverlauf beschrieben. In diesem Beispiel wird als Wertelieferant ein kapazitiver Sensor angenommen. Der kapazitive Sensor liefert aufgrund einer Kapazitätsänderung des Sensors bei Veränderung der Umgebung zeitlich veränderliche Signale. Der Einsatz solcher kapazitiven Sensoren ist bei elektronischen Geräten, insbesondere aber auch bei Fahrzeug-Schließsystemen bekannt. Dort sind kapazitive Sensoren in "Keyless-Entry" Systemen in Türgriffen oder im Heckbereich von Fahrzeugen eingesetzt, um eine Annäherung eines Bedieners zu erfassen. Nähert ein Bediener seine Hand (bei einem Türgriff) oder seinen Fuß (im Falle eines sogenannten Kick-Sensors im Heckbereich zur Öffnung der Heckklappe) dem kapazitiven Sensor, wird die erfasste Kapazität verändert und aus der zeitlichen Änderung des Signals wird ein Bedienwunsch abgeleitet. Im Stand der Technik sind zahlreiche Verfahren zur Auswertung der Signalantworten eines kapazitiven Sensors im Bereich der Zugangssysteme bekannt. Beispielhaft wird auch auf das zu Figur 1 erläuterte Verfahren verwiesen.

Gemäß dem Ausführungsbeispiel der Erfindung wird eine Zeitfolge von Sensorsignalen $s_k$ mit einem kapazitiven Sensor erfasst. Der Index k kennzeichnet dabei die mit einem Zeitstand erfasste diskreten Werte. Die Zeitfolge der Werte lautet dann $s_0$, $s_1$, ..., $s_{k-1}$, $s_k$, $s_{k+1}$,...

Aus den Messwerten werden gemäß der nachfolgenden beispielhaften Vorschriften Intervallgrenzen abgeleitet:

$$LB((s_n)_n\ ,\ k;\ m,\ c_1,\ \lambda\ ) =$$
$$s_k + (1-\lambda) \cdot min\ (L((s_n)_n\ ;\ k,\ 0)\ ,\ c_1) +$$
$$\lambda \cdot min\ (L((s_n)_n\ ;\ k,\ m)\ ,\ c_1)$$

$$UB((s_n)_n\ ,k;\ m,\ c_2,\ \lambda) =$$
$$s_k + (1-\lambda) \cdot max\ (L((s_n)_n\ ;\ k,\ 0)\ ,\ c_2) +$$
$$\lambda \cdot max\ (L((s_n)_n\ ;\ k,\ m),\ c_2)$$

LB bezeichnet dabei die untere Intervallgrenze zu einem Messwert.
UB bezeichnet dabei die obere Intervallgrenze zu einem Messwert.
$c_1$, $c_2$, $\lambda$ bezeichnen Glättungsparameter. $\lambda$ kann beispielsweise als Potenz von 0.5 gewählt werden.
Der Ausdruck L(..,..,..) bezeichnet eine finite Differenz, welche aus dem Verlauf der Messdaten ermittelt wird.
Je nachdem, wie die Parameter k, m und $\lambda$ gewählt werden, hängen die Intervallgrenzen nicht nur von dem betrachteten Messwert $s_k$ ab, sondern es werden weitere, insbesondere vorangehende Messwerte einbezogen und es wird eine Glättung der Intervallgrenzen vorgenommen.

Wir jedoch bei einer einfachen Betrachtung $\lambda=0$ gewählt, so erfolgt keine Glättung (der letzte Summand entfällt). Werden z.B. die Parameter gewählt zu k, m = 0, $c_1$ = -0,5, $c_2$ = 0.5, $\lambda$ = 0, so vereinfacht sich die Berechnung der Intervallgrenzen zu

$$LB = s_k + min\ (s_k - s_{k-1},\ -0.5)$$

$$UB = s_k + max\ (s_k - s_{k-1},\ 0.5)$$

Die Intervallgrenzen werden ausgehend vom aktuellen Messwert berechnet, wobei ein negativer Anteil der Steigung der Messwerte mit einem Mollifier zur Bildung der unteren Intervallgrenze verwendet wird und der positive Anteil der Änderung der Steigung mit einem positiven Mollifier verwendet wird, um die obere Intervallgrenze zu berechnen. Die untere Intervallgrenze LB zu dem Messwert $s_k$ verläuft also wenigstens 0.5 Einheiten unterhalb $s_k$, die obere Schranke UB liegt wenigstens 0.5 Einheiten oberhalb von $s_k$. In Bereichen starker Steigungen und Dynamik, dort wo $s_k - s_{k-1} < -0.5$ oder
$s_k - s_{k-1} > 0.5$ werden diese Schranken jedoch weiter gegenüber dem Messwert $s_k$ beabstandet.

Diese Berechnung der Intervallgrenzen wird vor der eigentlichen Auswertung von Messwerten zur Bildung einer Schablone mit einem Musterverlauf von Werten vorgenommen. Dafür wird zum Beispiel eine Musterbetätigung an einem kapazitiven Sensor zur Erzeugung einer Datenfolge vorgenommen und es werden die Intervallgrenzen zu dem Musterverlauf gespeichert. Diese Schablone aus Intervallgrenzen kann mit anderen Parametern erstellt werden als in der späteren Auswertung Verwendung finden. z.B. kann im vorstehenden Fall für die Erstellung und Speicherung der Schablonen ein Parametersatz mit k, m = 0, $c_1$ = -0.7, $c_2$ = 0.7, $\lambda$ = 0 Verwendung finden. Die Schablone ist dann stärker aufgeweitet als die Intervalle in den späteren Auswertungen.

Statt dem vorstehenden Beispiel kann eine komplexere Anpassung der Intervallgrenzen erfolgen, indem z.B. die Parameter zu m = 15, $c_1$ = -0.1, $c_2$ = 0.1, $\lambda$ = 0.75 gewählt werden.

$$LB = s_k + (0.25)min\ (L((s_n)_n\ ;\ k,\ 0)\ ,\ -0.1) +$$
$$0.75\ min\ (L((s_n)_n\ ;\ k,\ 15)\ ,\ -0.1)$$

$$UB = s_k + (0.25)max\ (L((s_n)_n\ ;\ k,\ 0)\ ,\ 0.1) +$$
$$0.75\ max\ (L((s_n)_n\ ;\ k,\ 15)\ ,\ 0.1)$$

Die Wahl der Parameter sorgt in diesem Fall für eine Einbeziehung weiterer Messwerte aus dem Zeitverlauf in die Berechnung der Intervallgrenzen. Auf diese Weise wirkt eine starke Signaldynamik oder auch ein vorangehendes starkes Rauschen auch auf die Intervallgrenzen nachfolgender Messwerte nach.

Die Wahl von $\lambda$ = 0.75 sorgt für eine Glättung, so dass die Intervallgrenzen sich wieder mit einer gewissen "Dämpfung" der zeitlichen Dynamik anpassen.

Wesentlich ist, dass erfindungsgemäß Schablonen aus Musterwerten gebildet werden, wobei die Schablonen einer Berechnungsvorschrift folgen und Intervallgrenzen definieren. In einer Messwertauswertung werden zu aktuellen Messwerten ebenfalls Intervallgrenzen bestimmt und es wird geprüft, ob sich die aktuellen Intervallgrenzen innerhalb der Intervallgrenzen der Schablonen befinden. Die Berechnungsanweisungen für die Erstellung der Schablonen und für die Berechnung der Intervallgrenzen können identisch sein, es können aber auch strukturell gleiche oder ähnliche Berechnungsvorschriften mit abweichenden Parametersätzen verwendet werden, so dass die Schablonen mit anderen Parametern berechnet werden als die Intervallgrenzen der aktuellen Messwerte.

## Patentansprüche

1.  Verfahren zum Auswerten von Signalverläufen an Sensoreinrichtungen, mit den Schritten:

    Erfassen von wenigstens einem zeitlichen Signalverlauf (6; 10a) mit einer Sensoreinrichtung,
    Bestimmen von zeitlichen Abschnitten des Signalverlaufs (6; 10a),
    Berechnen von wenigstens einem oberen Ist-Intervallwert (7a; 11a) und wenigstens einem unteren Ist-Intervallwert (7b; 11b) zu jedem der zeitlichen Abschnitte gemäß einer Berechnungsvorschrift, wobei die Berechnungsvorschrift wenigstens die Signale des zugeordneten Signalabschnittes einbezieht,
    **gekennzeichnet durch**
    15 Vergleichen der berechneten oberen Ist-Intervallwerte (7a; 11a) und unteren Ist-Intervallwerte (7b; 11b) jedes Abschnitts mit gespeicherten Vergleichs-Intervallwerten (5a, 5b;) zugeordneter Abschnitte, wobei bestimmt wird, ob für jeden Abschnitt das Intervall zwischen den Ist-Intervallwerte innerhalb des Intervalls der Vergleichs-Intervallwerte liegt.

2.  Verfahren nach Anspruch 1, wobei jeder Abschnitt wenigstens einen Signal-Messwert enthält.

3.  Verfahren nach Anspruch 1 oder 2, wobei der wenigstens eine obere Ist-Intervallwert und wenigstens eine untere Ist-Intervallwert zu jedem der zeitlichen Abschnitte der Signalwerte derart berechnet werden, dass im jeweiligen Abschnitt die Signalwerte zwischen oberem Ist-Intervallwert und unterem Ist-Intervallwert liegen.

4.  Verfahren nach einem der vorangehenden Ansprüche, wobei aus dem zeitlichen Signalverlauf eine stückweise affine Funktion für eine Offset-Korrektur berechnet wird,
    wobei die Offset-korrigierten Signaldaten verwendet werden, um die Ist-Intervallwerte zu berechnen.

5.  Verfahren nach einem der vorangehenden Ansprüche, wobei der zeitliche Signalverlauf zunächst einer Filterung unterworfen wird, vorzugsweise einem Glättungsfilter.

6.  Verfahren nach einem der vorangehenden Ansprüche, wobei der zeitliche Signalverlauf zunächst normalisiert zugeführt wird, wobei die Normalisierung in Abhängigkeit von einer Vergleichsoperation mit der Intervallbreite und der Intervallbreite berechnet wird.

7.  Verfahren nach einem der vorangehenden Ansprüche, wobei die gespeicherten Vergleichs-Intervallwerte aus einem Muster-Signalverlauf berechnet und dauerhaft gespeichert werden.

## Claims

1.  A method for evaluating signal progressions on sensor devices, comprising the steps of:

    detecting at least one temporal signal progression (6;
    10a) with a sensor device,
    determining temporal sections of the signal progression (6; 10a),
    computing at least one upper actual interval value (7a; 11a) and at least one lower actual interval value (7b;

11b) for each of the temporal sections according to a computation rule, wherein the computation rule includes at least the signals of the associated signal section,
**characterised by**
comparing the computed upper actual interval values (7a; 11a) and the lower actual interval values (7b; 11b) of each section with stored comparison interval values (5a; 5b) of associated sections, wherein it is determined whether for each section the interval between the actual interval values lies within the interval of the comparison interval values.

**2.** The method according to claim 1, wherein each section contains at least one signal measured value.

**3.** The method according to claim 1 or 2, wherein the at least one upper actual interval value and the at least one lower actual interval value for each of the temporal sections of the signal values are computed in such a way that in the respective section the signal values lie between the upper actual interval value and the lower actual interval value.

**4.** The method according to one of the preceding claims, wherein a piecewise affine function is computed for an offset correction from the temporal signal progression,
wherein the offset-corrected signal data is used for computing the actual interval values.

**5.** The method according to one of the preceding claims, wherein the temporal signal progression is initially subjected to filtering, preferably a smoothing filter.

**6.** The method according to one of the preceding claims, wherein the temporal signal progression is initially supplied normalised, wherein normalisation is computed in dependence of a comparison operation with the interval width and the interval width.

**7.** The method according to one of the preceding claims, wherein the stored comparison interval values are computed from a sample signal progression and permanently stored.

**Revendications**

**1.** Procédé pour évaluer des courbes de signaux au niveau de dispositifs de détection, avec les étapes suivantes :

la détection d'au moins une courbe de signal dans le temps (6 ; 10a) avec un dispositif de détection,
la détermination de segments temporels de la courbe de signal (6 ; 10a),
le calcul d'au moins une valeur d'intervalle réelle supérieure (7a ; 11a) et d'au moins une valeur d'intervalle réelle inférieure (7b ; 11b) pour chacun des segments temporels conformément à une règle de calcul, dans lequel la règle de calcul tient au moins compte des signaux du segment de signal associé,
**caractérisé par**
la comparaison des valeurs d'intervalle réelles supérieures (7a ; 11a) et des valeurs d'intervalle réelles inférieures (7b ; 11b) calculées de chaque segment avec des valeurs d'intervalle comparatives (5a, 5b) enregistrées de segments associés, dans lequel on détermine si, pour chaque segment,
l'intervalle entre les valeurs d'intervalle réelles se situe dans les limites de l'intervalle des valeurs d'intervalle comparatives.

**2.** Procédé selon la revendication 1, dans lequel chaque segment contient au moins une valeur de mesure de signal.

**3.** Procédé selon la revendication 1 ou 2, dans lequel l'au moins une valeur d'intervalle réelle supérieure et au moins une valeur d'intervalle réelle inférieure peuvent être calculées pour chacun des segments temporels des valeurs de signal d'une manière telle, que dans le segment respectif, les valeurs de signal se situent entre la valeur d'intervalle réelle supérieure et la valeur d'intervalle réelle inférieure.

**4.** Procédé selon l'une des revendications précédentes, dans lequel on calcule, à partir de la courbe de signal dans le temps, une fonction affine morceau par morceau pour une correction d'offset,
dans lequel les données de signal à offset corrigé sont utilisées pour calculer les valeurs d'intervalle réelles.

**5.** Procédé selon l'une des revendications précédentes, dans lequel la courbe de signal dans le temps est tout d'abord soumise à un filtrage, de préférence à un filtre de lissage.

6. Procédé selon l'une des revendications précédentes, dans lequel la courbe de signal dans le temps est tout d'abord amenée de façon normalisée, dans lequel la normalisation est calculée en fonction d'une opération de comparaison avec la largeur d'intervalle et la largeur d'intervalle.

7. Procédé selon l'une des revendications précédentes, dans lequel les valeurs d'intervalle comparatives enregistrées sont calculées à partir d'une courbe de signal modèle et sont enregistrées de façon durable.

Fig. 1

Fig. 2

Fig. 3

10

11

Fig. 4

5a

11a

10a

5b

11b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2616287 A1
- US 2002173935 A1
- DE 102012100960 A1